# EUROPÄISCHE PATENTSCHRIFT

(11) **EP 0 639 293 B1**
(45) Veröffentlichungstag und Bekanntmachung des Hinweises auf die Patenterteilung: **23.12.1998**
(21) Anmeldenummer: 94909106.0
(22) Anmeldetag: 03.03.1994
(51) Int. Cl.: H01L 21/00

(54) **Einrichtung zur Indexierung von Magazinfächern eines Magazins und darin enthaltenen scheibenförmigen Objekten**
DEVICE FOR INDEXING MAGAZINE COMPARTMENTS AND WAFER-SHAPED OBJECTS IN THE COMPARTMENTS
DISPOSITIF PERMETTANT D'INDEXER LES COMPARTIMENTS D'UN MAGASIN ET LES OBJETS SE PRESENTANT SOUS FORME DE TRANCHES CONTENUS DANS CES COMPARTIMENTS

(30) Priorität: 05.03.1993 DE 4306957
(43) Veröffentlichungstag der Anmeldung: 22.02.1995
(73) Patentinhaber: JENOPTIK Aktiengesellschaft, D-07743 Jena (DE)
(72) Erfinder: BIRKNER, Andreas, D-07743 Jena (DE); LAHNE, Berndt, D-07747 Jena (DE); SCHULTZ, Klaus, D-07745 Jena (DE)
(74) Vertreter: Geyer, Werner, Dr.-Ing.
(86) Internationale Anmeldenummer: EP9400620
(87) Internationale Veröffentlichungsnummer: WO9420979

(56) Entgegenhaltungen:
- WO-A-92/05920
- US-A- 4 803 373
- US-A- 4 895 486
- US-A- 5 044 752

## Beschreibung

Die Erfindung betrifft eine Einrichtung zur Indexierung von Magazinfächern eines Magazins und darin enthaltenen scheibenförmigen Objekten, insbesondere Halbleiterscheiben und Schablonen, zu deren Bearbeitung das Magazin mittels einer Magazinaufnahme einer Scheibenhandhabungseinrichtung durch einen Magazinlift meßbar in der Höhe gegenüber einer Handhabungsebene zur Entnahme und Beschickung verstellbar ist.
Derartige technische Lösungen sind bei der Herstellung integrierter Schaltkreise, insbesondere für Handhabungsaufgaben anwendbar und beispielsweise aus der US 4 895 486 bekannt.

Bei der Herstellung integrierter Schaltkreise müssen Halbleiterscheiben zwischen unterschiedlichen Bearbeitungsschritten zu einzelnen Bearbeitungsmaschinen transportiert werden. In zunehmendem Maße geschieht dies in standardisierten Transportbehältern, sogenannten Standard Mechanical Inter Face Boxen (SMIF-Boxen), auf deren Boden das Magazin, in dessen Fächern sich die Halbleiterscheiben befinden, in geeigneter Weise fixiert ist.
Zur Beschickung der Bearbeitungsmaschinen werden die Magazine aus den Transportbehältern mit geeigneten Mitteln entladen und die Halbleiterscheiben mit einer Entnahme- und Beschickungsvorrichtung entnommen. Nach der Bearbeitung erfolgt sowohl deren Rückführung in die Fächer des Magazins als auch die des Magazins in den Transportbehälter.

Ein möglicher Einsatz von Staudrucksensoren oder Reflexkopplern, die die Halbleiterscheiben im Magazin detektieren, besitzt den Nachteil, daß die Abarbeitung des Magazins in einer bestimmten Reihenfolge erfolgen muß. Dabei können die Halbleiterscheiben nicht wahlfrei aus dem Magazin entnommen werden, sondern das Beschickungsmagazin muß von unten nach oben geleert und das Ausgabemagazin muß von oben nach unten gefüllt werden, bedingt durch die erforderliche Sensoranordnung und der damit verbundenen Entnahme bzw. Zuführung der Halbleiterscheiben. Dadurch bleibt die Zuordnung der Halbleiterscheibe zu einer bestimmten Etage nicht erhalten.
Sowohl bei der Inspektion übliche Stichprobenentnahmen als auch ein Einsatz in den bereits genannten Transportbehältem sind mit derartigen technischen Lösungen nicht möglich.

Gemäß der US-Patentschrift 4 895 486 ist es bekannt, mit einem Kontrollgerät die Anwesenheit scheibenförmiger Objekte in einem Träger (Magazin) und deren relative Lage zu einer Bezugsebene in dem Träger zu bestimmen, indem ein erstes Signal für die Anwesenheit eines derartigen Objektes und ein Ortssignal für das Objekt miteinander verknüpft werden.
Das erste Signal wird durch einen optoelektronischen Sensor gewonnen, der den Raum, in dem sich die Objekte befinden können, überwacht. Das zweite Signal entsteht über einen mit einem Antrieb zum Auf- und Abfahren des Trägers gekoppelten Positionsencoder.
Zur Bestimmung der Bezugsebene und des möglichen Aufenthaltsraumes der Objekte wird der Raum im Träger vertikal in Segmente aufgeteilt. Neben einem als Bezugsebene dienenden Segment und Segmenten ohne scheibenformige Objekte, werden Window-Segmente definiert, in denen Objekte vorhanden sein können. Es erfolgt eine Indexierung des Trägers, indem nach einer meßtechnischen Erfassung der Bezugsebene in dem Träger die Orte der Window-Segmente rechnerisch über die Konstruktionsdaten des jeweils verwendeten Trägers ermittelt und gespeichert werden.

Mit der beschriebenen Lösung kann zwar die Anzahl der Objekte und deren Ablageorte relativ zu einer Bezugsebene innerhalb des Trägers bestimmt werden. Jedoch ist zur Entnahme der Objekte aus dem Träger dieser oder die Entnahme- und Beschickungsvorrichtung im Rastermaß der Fächer des Trägers zu positionieren. Voneinander abweichende Trägergeometrien und Toleranzen müssen dabei berücksichtigt werden oder Fehler sind nicht auszuschließen. Probleme treten besonders dann auf, wenn ein leerer Träger beliebig beschickt werden soll.

Es ist außerdem möglich, durch einen weiteren optoelektronischen Sensor die richtige Lage des Objektes im Träger bei dessen Transport in vertikaler Aufwärtsrichtung zu kontrollieren. Damit soll verhindert werden, daß Objekte, die durch fehlerhafte oder nicht korrekte Handhabung aus dem Träger herausragen, bei der Rückführung in den Transportbehälter beschädigt werden. Wird ein aus dem Träger herausragendes Objekt erkannt, wird der Transport des Magazins gestoppt und es macht sich ein manueller Eingriff des Operators zur Fehlerbeseitigung erforderlich.
Das Erkennen herausragender Objekte ist zwar sinnvoll, der notwendige manuelle Eingriff verzögert jedoch unnötig jede Weiterbearbeitung mit Störungen der Reinraum- und unter Umständen der Klimabedingungen der Bearbeitungsmaschine innerhalb der Maschineneinhausung. Die Folge kann der Ausfall der Maschine sein.

Es besteht deshalb die Aufgabe, einen genauen Zugriff der Entnahme- und Beschickungsvorrichtung in jede beliebige und vorherbestimmbare Ebene des Magazins unabhängig von Abmessungstoleranzen zu gewährleisten und somit den mit einer zusätzlichen Anpassung verbundenen Aufwand zu vermeiden und den Einsatz der beschriebenen Transportbehälter flexibler zu gestalten.
Außerdem ist bei Erkennen von Fehllagen der Halbleiterscheiben die unmittelbare Weiterarbeit zu sichern.

Erfindungsgemäß wird die Aufgabe durch eine Einrichtung zur Indexierung von Magazinfächern eines Magazins und darin enthaltenen scheibenförmigen Objekten, insbesondere Halbleiterscheiben und Schablonen, zu deren Bearbeitung das Magazin mittels einer Magazinaufnahme einer Scheibenhandhabungseinrichtung durch einen Magazinlift meßbar in der Höhe gegenüber einer ersten Handhabungsebene zur Entnahme und Beschickung verstellbar ist, mit einen aus Sender und Empfänger bestehenden optoelektronischen Sensor, der mit seinem Meßstrahlenbündel die scheibenförmigen Objekte in ihrer Lage relativ zu einer Bezugsebene erfaßt, dadurch gelöst, daß das Meßstrahlenbündel auch die Lage der Magazinfächer relativ zu der Bezugsebene erfaßt und die Bezugsebene in der Scheibenhandhabungseinrichtung konstruktiv mit der ersten Handhabungsebene in fester Beziehung steht.

Das von dem Sender ausgehende, mit seinem Mittenstrahl in der Bezugsebene liegende Meßstrahlenbündel ist zwischen gegenüberliegenden, die Magazinfächer enthaltenden Wänden hindurchgeführt und auf das Meßstrahlenbündel abschattende, in das Innere des Magazins weisende fächerbildende Vorsprünge einer der Wände gerichtet, die als Auflage für die scheibenförmigen Objekte dienen. Durch die Höhenverstellung in Richtung der übereinanderliegenden Magazinfächer, die dadurch aufeinanderfolgend eine gemeinsame Lage mit der Bezugsebene einnehmen, erfolgt eine Erzeugung eines Abbildes sowohl der Magazinfächer als auch der in den Magazinfächern befindlichen scheibenförmigen Objekte durch eine Modulation des Meßstrahlenbündels.

Mit einem einzigen Sensorsystem werden die Magazinfächer selbst und darin enthaltene Objekte meßtechnisch erfaßt, wodurch die tatsächlich gegebenen Verhältnisse ermittelt werden, im Gegensatz zu einer rechentechnischen Bestimmung der Lage eines Magazinfaches aus den Konstruktionsdaten oder der Bestimmung der Lage anhand eines Indexermaßstabes. Dadurch sind Entnahme und Rückführung beliebig ausführbar, wodurch Umsortierungen in jeder Art und Weise, auch zwischen Magazinen mit unterschiedlichem Fächerabstand sowohl untereinander als auch zu einer Bezugsebene innerhalb des Magazins möglich werden. Auch leere Magazine können beliebig gefüllt werden.

Zur Positionierung aus dem Magazin herausragender scheibenförmiger Objekte ist eine Scheibenrückführeinrichtung in einer zweiten Handhabungsebene parallel zur ersten Handhabungsebene vorgesehen. Das Wirksamwerden der Scheibenrückführeinrichtung ist an ein Sensorsignal eines zweiten Sensors gebunden, dessen Meßstrahlenbündel parallel zu den scheibenförmigen Objekten gerichtet und bei der Höhenverstellung des Magazins dessen zur Entnahme und Beschickung dienenden Seite unmittelbar benachbart ist.

Die Scheibenrückführeinrichtung führt, ausgelöst durch das Sensorsignal, das Objekt ohne äußere Eingriffe in das Magazinfach zurück. Ohne einen manuellen Eingriff wird ein Weitertransport des Magazins in den Transportbehälter gewährleistet und eine Beschädigung herausragender Objekte vermieden.

Ein Ausfuhrungsbeispiel der Erfindung soll nachstehend anhand der schematischen Zeichnung näher erläutert werden. Es zeigen:
- Fig. 1: einen Teil einer Scheibenhandhabungseinrichtung teilweise im Schnitt
- Fig. 2: die Anordung eines optoelektronischen Sensors in Verbindung mit einer Schnittdarstellung durch das Magazin
- Fig. 3: die Vorderansicht eines Magazins mit Querschnittsdarstellung eines Meßstrahlenbündels
- Fig. 4: in benachbarter Darstellung einen Ausschnitt aus einem der Wände des Magazins mit eingeschobenen scheibenförmigen Objekten und ein mittels des optoelektronischen Sensors abgetastetes Bild des Ausschnittes
- Fig. 5: eine Draufsicht auf das Magazin mit einem zweiten Sensor und einer Scheibenrückführeinrichtung
- Fig. 6: in einem Blockschaltbild die Verknüpfung von Steuer-, Verarbeitungs- und Auswerteeinheiten mit übrigen Einheiten zur Ausführung der Erfindung

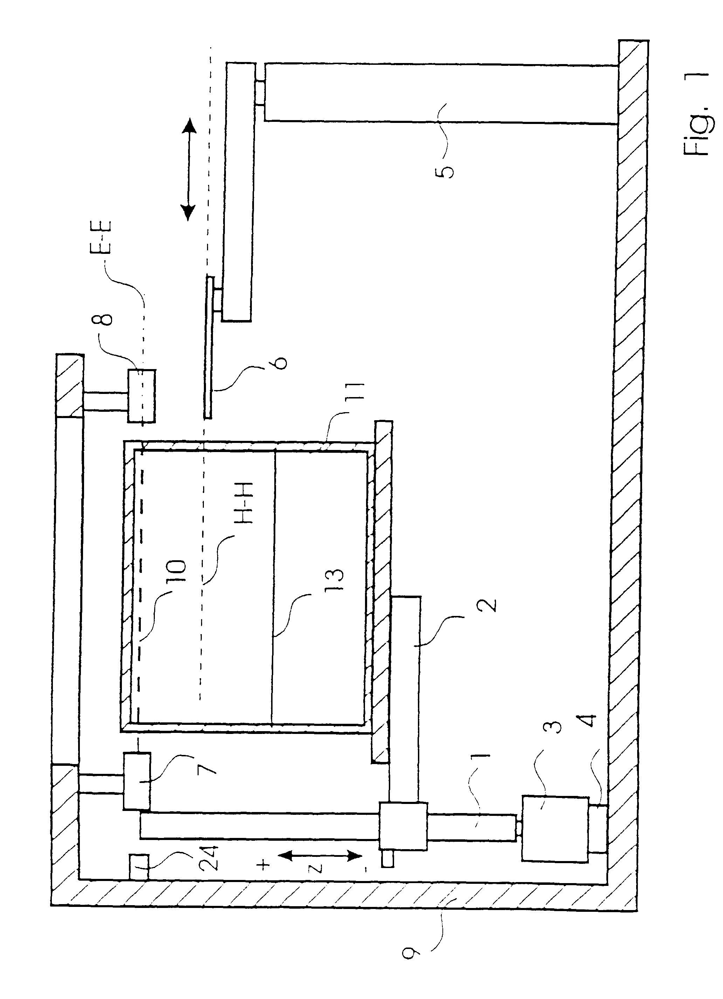

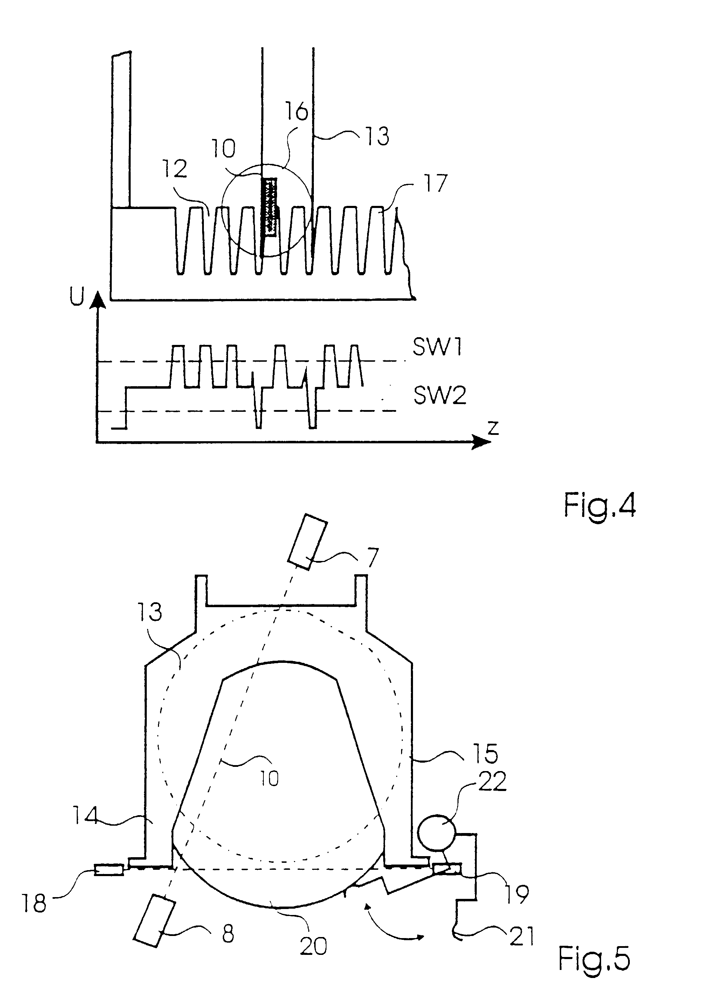

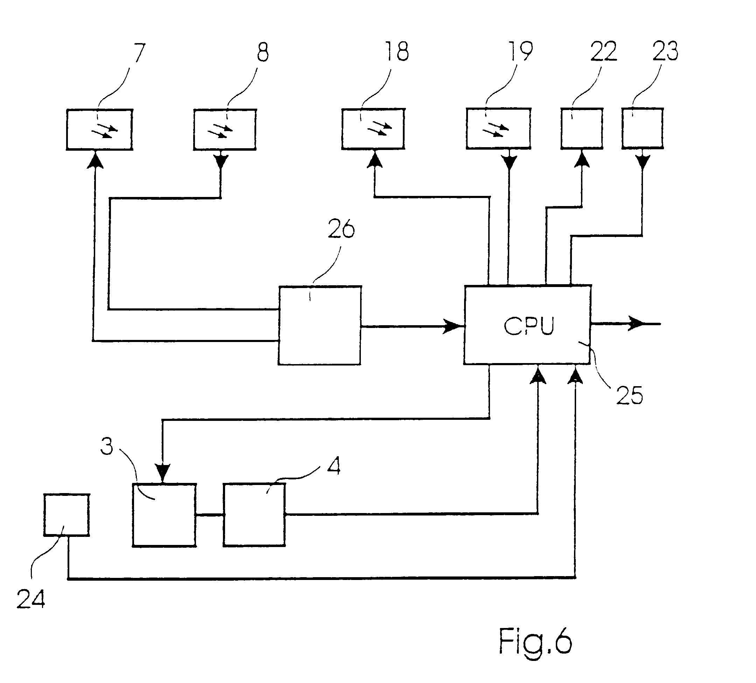

Eine Scheibenhandhabungseinrichtung, von der in Fig. 1 lediglich ein Teil dargestellt ist, besitzt in ihrem Inneren eine über einen Spindelantrieb 1 in z-Richtung (senkrecht zur Aufstellfläche der Scheibenhandhabungseinrichtung) anheb- und absenkbare Magazinaufnahme 2. Der Antrieb der Spindel 1 erfolgt mit Hilfe eines Schrittmotors 3, der mit einem Winkelmeßsystem 4 ausgerüstet ist, so daß über die Spindelsteigung der zurückgelegte Weg beim Anheben oder Absenken ermittelt werden kann.
Der Schrittmotor 3 mit seiner Ansteuerelektronik und das Winkelmeßsystem 4 bilden gemeinsam mit einem Steuerrechner 25 gemäß Fig. 6 einen Positionsregler eines Magazinlifts, zu dem außerdem die Spindel 1 und die Magazinaufnahme 2 gehören. Eine Entnahme- und Beschickungsvorrichtung 5 besitzt einen in einer Handhabungsebene H-H arbeitenden Handhabungsarm 6 und ist wie der Magazinlift und ein optoelektronischer Sensor, der aus einem Sender 7 und einem Empfänger 8 besteht, an einem gemeinsamen Rahmen 9 befestigt. Ein von dem Sender 7 ausgehendes Meßstrahlenbündel 10 verläuft mit seinem Mittenstrahl in einer Bezugsebene E-E zur Indexierung von in einem Magazin 11 befindlichen, der Übersicht halber erst in Fig. 3 dargestellten Magazinfächern 12 und darin enthaltenen scheibenförmigen Objekten 13.
Der Abstand zwischen der Ebene E-E und der Handhabungsebene H-H ist innerhalb des Fahrbereiches des Spindelantriebes 1 wählbar.

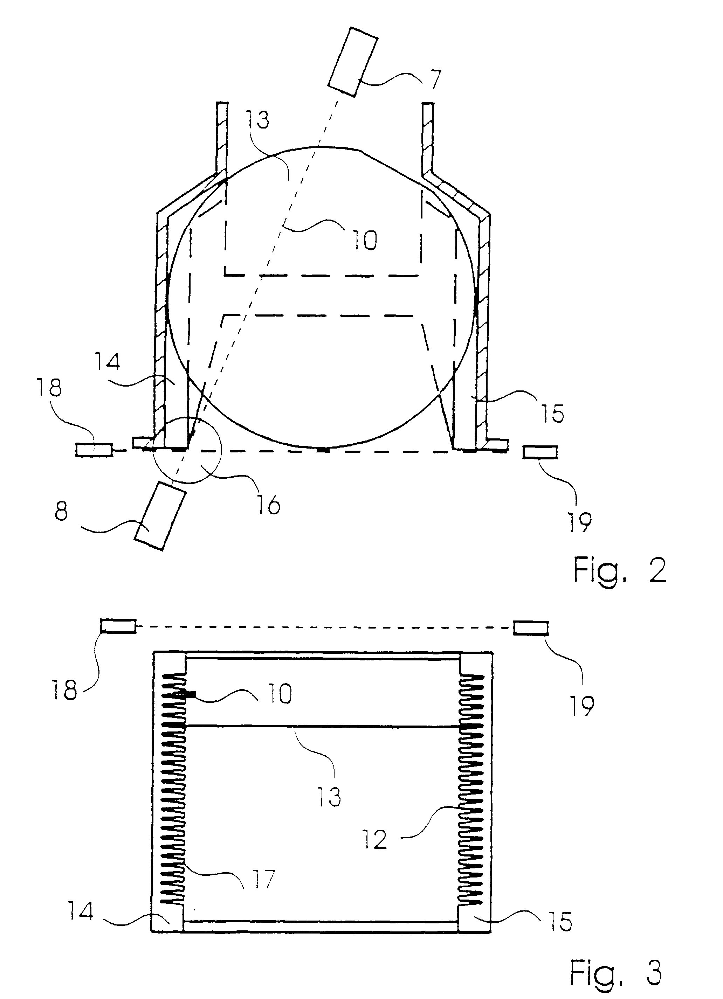

Die Figuren 2 und 3 verdeutlichen die Anordnung des Sensors in Bezug auf das Magazin 11 und in die Magazinfächer 12 möglicherweise eingeschobene scheibenförmige Objekte 13, wie z.B. Halbleiterscheiben oder Schablonen. Danach sind der Sender 7 und der Empfänger 8 so gelegt, daß das Meßstrahlenbündel 10 zwischen Wänden 14, 15 des Magazins 11 hindurchgeführt und auf einen Eckenabschnitt 16 gerichtet ist. Der Eckenabschnitt 16 reicht entsprechend Fig. 4 soweit in das Meßstrahlenbündel 10, daß in das Innere des Magazins 11 gerichtete Vorsprünge 17, die als Auflagen für die scheibenförmigen Objekte 13 dienen, das Meßstrahlenbündel 10 abschatten.
Die dargestellte schräge Durchstrahlung des Magazins 11 wurde gewählt, da dieses rückseitig meist teilweise verschlossen ist. Liegt ein derartiger Abschluß nicht vor, ist natürlich auch eine zu den Wänden 14 und 15 und den Magazinfächern 12 parallele Strahlenführung des Meßstrahlenbündels 10 möglich. Der Mittenstrahl des Meßstrahlenbündels 10 verläuft vorteilhafterweise direkt an der Vorderkante der Vorsprünge 17 entlang.

Neben dem ersten Sensor ist dem Magazin 10 auf dessen zur Entnahme und Beschickung dienenden Seite ( der Entnahme- und Beschickungsvorrichtung 5 zugewandte Seite) ein weiterer, aus einem Sender 18 und einem Empfänger 19 bestehender Sensor benachbart, der einen definierten Abstand zum ersten Sensor besitzt und aus dem Magazin 11 herausragende Objekte 20 beim Transport des Magazins 11 in positiver z-Richtung erkennt.

Wie in Fig. 5 dargestellt, ist zur Positionierung des aus dem Magazin 11 herausragenden Objektes 20, eine Scheibenrückführeinrichtung 21 vorgesehen, die in einer zweiten zur ersten Handhabungsebene H-H parallelen Handhabungsebene aufgrund der mit dem ersten Sensor gewonnenen Ortsinformation die Verschiebung des Objektes 20 in das Magazin 11 übernimmt. Damit kann der Transport des Magazins 11 ungestört ohne einen manuellen Eingriff fortgeführt werden.
Die Scheibenrückführeinrichtung 21 besteht aus einem elektromotorisch angetriebenen Hebelmechanismus 22, der bei einer Umdrehung seines Antriebs (nicht dargestellt) eine Schwenkbewegung von 90° ausführt. Der Umkehrpunkt des Hebels des Mechanismus 22 ist so angeordnet, daß er das Objekt 20 in das Magazin 11 schiebt und sich anschließend in eine Ausgangslage zurück begibt, die mit einem Endschalter 23 überwacht wird.

Gemäß Fig. 6 sind zur Ausführung der Erfindung der Schrittmotor 3, das Winkelmeßsystem 4, die Sender 7 und 18, die Empfänger 8 und 19, ein dritter, mit dem Rahmen 9 fest verbundener Sensor 24, der Hebelmechanismus 22 und der Endschalter 23 mit einem Steuerrechner 25 in der dargestellten Weise verknüpft. Zwischen den Sensoren und den Steuerrechner 25 sind AD-Wandler geschaltet, von denen ein AD-Wandler 26 eingezeichnet ist.

Nachdem die Magazinaufnahme 2 gegenüber dem dritten Sensor 24, der fest mit dem Rahmen 9 verbunden ist und einen bekannten Abstand zur Handhabungsebene H-H und zur Bezugsebene E-E besitzt, positioniert und der Zähler des Winkelmeßsystems genullt wurde, wird zur Indexierung der Magazinfächer 12 und der darin befindlichen scheibenförmigen Objekte 13 das Magazin 11 aus einem nicht dargestellten staubschützenden Transportbehälter mit dessen Boden automatisch entnommen und von der Magazinaufnahme 2 übernommen. Danach wird die Magazinaufnahme 2 abgesenkt, also in negative z-Richtung gefahren, bis ein Schwellwert sw2 von vorteilhafterweise zur Datenreduzierung festgelegten Schwellwerten sw1 und sw2 überschritten wird. Damit ist vom Magazins 11 der Abstand seines Bodens zur Bezugsebene E-E erfaßt.
Bei der Bewegung des Magazins 11 in Richtung seiner übereinanderliegenden Magazinfächer 12 durch die Ebene E-E erhält man ein die Magazinfächer 12 und die Objekte 13 als Abbild darstellendes amplitudenmoduliertes Sensorausgangssignal U als Funktion des Weges entsprechend Fig. 4 am Empfänger 8, das dem AD-Wandler 26 zugeführt und mit Hilfe des Steuerrechners 25 mit dem Meßsignal des Winkelmeßsystems 4 verknüpft und gespeichert wird.
Um ein Objekt 13 aus dem Magazin 11 zu entnehmen oder in ein leeres Magazinfach 12 zu plazieren, wird zu dem ermittelten Zählerstand ein Wert für den Abstand zwischen der Ebene E-E und der ersten Handhabungsebene H-H addiert und das Magazin 11 mit Hilfe des Magazinlifts in die entsprechende z-Position gefahren.

Sofern es die Umgebungsbedingungen beim Transport der scheibenförmigen Objekte 13 zulassen, kann natürlich auf besonders schützende Transportbehälter der genannten Art verzichtet werden. Die Magazinaufnahme 2 übernimmt in diesem speziellen Fall das Magazin direkt ohne Überführung aus dem Transportbehälter.

## Patentansprüche

1. Einrichtung zur Indexierung von Magazinfächern eines Magazins und darin enthaltenen scheibenförmigen Objekten, insbesondere Halbleiterscheiben und Schablonen, zu deren Bearbeitung das Magazin (11) mittels einer Magazinaufnahme (2) einer Scheibenhandhabungseinrichtung durch einen Magazinlift meßbar in der Höhe gegenüber einer ersten Handhabungsebene (H-H) zur Entnahme und Beschickung verstellbar ist, mit einem aus Sender (7) und Empfänger (8) bestehenden optoelektronischen Sensor, der mit seinem Meßstrahlenbündel (10) die scheibenförmigen Objekte (13) in ihrer Lage relativ zu einer Bezugsebene (E-E) erfaßt, dadurch gekennzeichnet, daß
das Meßstrahlenbündel (10) auch die Lage der Magazinfächer (12) relativ zu der Bezugsebene (E-E) erfaßt und die Bezugsebene (E-E) in der Scheibenhandhabungseinrichtung konstruktiv mit der ersten Handhabungsebene (H-H) in fester Beziehung steht.

2. Einrichtung nach Anspruch 1, dadurch gekennzeichnet, daß das von dem Sender (7) ausgehende, mit seinem Mittenstrahl in der Bezugsebene (E-E) liegende Meßstrahlenbündel (10) zwischen gegenüberliegenden, die Magazinfächer (12) enthaltenden Wänden (14, 15) hindurchgeführt und auf das Meßstrahlenbündel (10) abschattende, in das Innere des Magazins (11) weisende, fächerbildende Vorsprünge (17) einer der Wände (14, 15) gerichtet ist, die als Auflage für die scheibenförmigen Objekte (13) dienen, und daß durch die Höhenverstellung in Richtung der übereinanderliegenden Magazinfächer (12), die dadurch aufeinanderfolgend eine gemeinsame Lage mit der Bezugsebene (E-E) einnehmen, eine Erzeugung eines Abbildes sowohl der Magazinfächer (12) als auch der in den Magazinfächern befindlichen scheibenförmigen Objekte (13) durch eine Modulation des Meßstrahlenbündels (10) erfolgt.

3. Einrichtung nach Anspruch 1 oder nach Anspruch 2, dadurch gekennzeichnet, daß zur Positionierung aus dem Magazin (11) herausragender scheibenförmiger Objekte (20) eine Scheibenrückführeinrichtung (21) in einer zweiten Handhabungsebene parallel zur ersten Handhabungsebene (H-H) vorgesehen ist, deren Wirksamwerden an ein Sensorsignal eines zweiten Sensors (24) gebunden ist, dessen Meßstrahlenbündel parallel zu den scheibenförmigen Objekten (13, 20) gerichtet und bei der Höhenverstellung des Magazins (11) dessen zur Entnahme und Beschickung dienenden Seite unmittelbar benachbart ist.

## Claims

1. A device for indexing compartments of a magazine and disc-shaped objects, particularly semiconductor discs and master discs, contained therein, for processing whereof the magazine (11) is adjustable as to height, via a lift, by a magazine holder (2) belonging to a disc manipulating device, the adjustment being measurable relative to a first manipulating plane (H-H) for withdrawal and loading, the device comprising an opto-electronic sensor comprising a transmitter (7) and receiver (8), the measuring beam (10) from the sensor detecting the position of the disc-shaped objects (13) relative to a reference plane (E-E), characterised in that the measuring beam (10) also detects the position of the magazine compartments (12) relative to the reference plane (E-E), and the reference plane (E-E) in the disc manipulating device are in a constant relation, determined by the construction, to the first manipulating plane (H-H).

2. A device according to claim 1, characterised in that the measuring beam (10) leaving the transmitter (7) and with its centre ray in the reference plane (E-E) travels between facing walls (14, 15) containing the magazine compartments (12) and is directed on to compartment-forming projections (17) from one wall (14, 15) which point towards the interior of the magazine (11) and obscure the measuring beam (10) and support the disc-shaped objects (13), and the height adjustment in the direction of the superposed magazine compartments (12), which consequently successively occupy the same position as the reference plane (E-E), results in generation of an image both of the magazine compartments (12) and of the disc-shaped objects (13) in the magazine compartments, through modulation of the measuring beam (10).

3. A device according to claim 1 or according to claim 2, characterised in that for the purpose of positioning disc-shaped objects (20) projecting from the magazine (11) a disc return device (21) is provided in a second manipulating plane parallel to the first manipulating plane (H-H) and operates in dependence on a signal from a second sensor (24) whose measuring beam is directed parallel to the disc-shaped object (13, 20) and, during adjustment of the magazine (11) as to height, is immediately adjacent the side thereof used for withdrawal and loading.

## Revendications

1. Dispositif d'indexation des compartiments d'un magasin et des objets en forme de disque y étant contenus, en particulier des plaquettes ou pastilles de semiconducteur et des gabarits, pour le traitement duquel le magasin (11) peut être réglé de façon mesurable en hauteur au moyen d'un support de magasin (2) d'un dispositif de manipulation de plaquettes par un élévateur de magasin par rapport à un premier plan de manipulation (H-H) pour le prélèvement et le garnissage, avec un capteur optoélectronique constitué d'un émetteur (7) et d'un récepteur (8), qui appréhende par son faisceau de rayons de mesure (10) les objets en forme de disque (13) en ce qui concerne leur position par rapport à un plan de référence (E-E), caractérisé en ce que le faisceau de rayons de mesure (10) appréhende également la position des compartiments de magasin (12) par rapport au plan de référence (E-E) et place le plan de référence (E-E) dans le dispositif de manipulation de plaquettes, de façon constructive en relation fixe par rapport au premier plan de manipulation (H-H).

2. Dispositif selon la revendication 1, caractérisé en ce que le faisceau de rayons de mesure (10) partant de l'émetteur (7) ayant son rayon médian placé dans le plan de référence (E-E) est passé entre des parois (14, 15) opposées, contenant les compartiments de magasin (12), et dirigé sur des saillies (17) formant les compartiments, tournées vers l'intérieur du magasin (11) et appartenant à l'une des parois (14, 15), occultant le faisceau de rayons de mesure (10), saillies servant de support pour les objets en forme de disque (13), et en ce que, par le réglage en hauteur en direction des compartiments de magasin (12) placés les uns au-dessus des autres, qui prennent les uns à la suite des autres de ce fait une position commune avec le plan de référence (E-E), s'effectue la génération d'une image tant des compartiments de magasin (12), qu'également des objets (13) en forme de disque se trouvant dans les compartiments de magasin, ceci au moyen d'une modulation du faisceau de rayons de mesure (10).

3. Dispositif selon la revendication 1 ou la revendication 2, caractérisé en ce que, pour le positionnement d'objets en forme de disque(20) sortant du magasin (11), est prévu un dispositif de guidage de retour de plaquettes (21), placé dans un deuxième plan de manipulation parallèle au premier plan de manipulation (H-H), dont l'action est liée à un signal de capteur venant d'un deuxième capteur (24), dont le faisceau de rayons de mesure est dirigé parallèlement aux objets en forme de disque (13, 20) et qui, lors du réglage en hauteur du magasin (11), est placé au voisinage direct de sa face, servant au prélèvement et au garnissage.
